Europäisches Patentamt

European Patent Office

Office européen des brevets

(19)

(11) Veröffentlichungsnummer: **0 207 571**
A2

(12) # EUROPÄISCHE PATENTANMELDUNG

(21) Anmeldenummer: 86201131.9

(22) Anmeldetag: 27.06.86

(51) Int. Cl.⁴: **H 04 N 9/79**

(30) Priorität: 03.07.85 DE 3523753

(43) Veröffentlichungstag der Anmeldung:
07.01.87 Patentblatt 87/2

(84) Benannte Vertragsstaaten:
AT DE FR GB

(71) Anmelder: Philips Patentverwaltung GmbH
Billstrasse 80
D-2000 Hamburg 28(DE)

(84) Benannte Vertragsstaaten:
DE

(71) Anmelder: N.V. Philips' Gloeilampenfabrieken
Groenewoudseweg 1
NL-5621 BA Eindhoven(NL)

(84) Benannte Vertragsstaaten:
FR GB AT

(72) Erfinder: Kupfer, Karl-Heinz
Krefelder Strasse 145
D-4150 Krefeld 29(DE)

(74) Vertreter: Kupfermann, Fritz-Joachim et al,
Philips Patentverwaltung GmbH Billstrasse 80 Postfach
10 51 49
D-2000 Hamburg 28(DE)

(54) Abgleichfreier Tiefpass für Video-Recorder.

(57) Die Erfindung bezieht sich auf einen Tiefpaß zur Bandbegrenzung und Verzögerung eines Fernseh-Luminanzsignals, insbesondere im Aufnahmezweig einer Video-Aufzeichnungsvorrichtung vor dem FM-Modulator. Die Dämpfung der Luminanzsignalanteile oberhalb einer Grenzfrequenz wird mit Hilfe eines gegen Masse geschalteten Keramikfilters (11, 31) und die Verzögerung des Luminanzsignals mittels einer in den Signalweg geschalteten Laufzeitleitung (7, 35) vorgenommen.

Fig.1

EP 0 207 571 A2

0207571

PHD 85-063 EP

BESCHREIBUNG

Abgleichfreier Tiefpaß für Video-Recorder

Die Erfindung bezieht sich auf einen Tiefpaß zur Bandbegrenzung eines Fernseh-Luminanzsignals, insbesondere des Luminanzsignals im Aufnahmezweig einer Video-Aufzeichnungsvorrichtung vor einem FM-Modulator, mit einer in einen Signalweg zwischen einen Eingang und einen Ausgang des Tiefpasses geschalteten Laufzeitleitung zur Verzögerung des Fernseh-Luminanzsignals.

Ein derartiger Tiefpaß ist bekannt aus Funkschau 15/1984, Seiten 42 bis 45.

In der Fernsehtechnik ist es oft erforderlich, Signale oberhalb einer Grenzfrequenz steilflankig zu unterdrücken. So müssen z. B. in Video-Recordern für eine einwandfreie Verarbeitung des Luminanzsignals alle Frequenzen oberhalb einer Grenzfrequenz unterdrückt werden. Diese Unterdrückung ist notwendig, da das Luminanzsignal vor dem Aufsprechen auf das Band FM-moduliert wird und zur Vermeidung von Störungen alle Signalfrequenzen oberhalb der FM-Trägerfrequenz unterdrückt werden müssen. Die Frequenz dieses Trägers liegt bei Heim-Video-Recordern bei 3 MHz. Das Luminanzsignal und das Farbsignal werden in getrennten Verstärkerzweigen verarbeitet und haben verschiedene Laufzeiten. Der Tiefpaß zur Unterdrückung höherer Frequenzen wird im Luminanzsignal meist auch gleichzeitig zur Laufzeitkorrektur verwendet.

Da ein solcher Tiefpaß insbesondere den Farbträger bei 4,43 MHz möglichst stark unterdrücken soll, andererseits jedoch bei 3 MHz eine möglichst geringe Dämpfung des Luminanzsignals bewirken soll, sind bekannte Tiefpaßfilter dieser Art in ihrem Aufbau meist sehr aufwendig. In diesen Filtern werden eine Vielzahl von Spulen verwendet, die bei der Herstellung auf eine bestimmte Induktivität genau abgeglichen werden müssen. Da die Induktivitäten in ihrem Wert sehr genau sein müssen, wirken sich auch Alterungseffekte entsprechend aus.

Es ist Aufgabe der Erfindung, einen Tiefpaß für Fernsehsignale zu schaffen, der im Aufbau möglichst einfach ist, jedoch gleichzeitig eine möglichst gute Unterdrückung der höheren Frequenzen gewährleistet bei gleichzeitig niedriger Beeinflussung der Signalfrequenzen unterhalb einer Grenzfrequenz.

Diese Aufgabe wird erfindungsgemäß dadurch gelöst, daß ein gegen Masse geschaltes Keramikfilter vorgesehen ist zur Dämpfung der Signalanteile oberhalb einer Grenzfrequenz.

Ein derartiges Filter bietet bei einfachstem Aufbau einen sehr guten Dämpfungsverlauf. Es ist abgleichfrei und gestattet durch entsprechende Widerstandswahl die gewünschten Abschlüsse des Ein- und Ausgangs. Die Bauelemente dieses Tiefpasses können automatisch bestückt werden. Ein wesentlicher Vorteil liegt auch in den kaum noch auftretenden Reflexionen von Signalanteilen im Filter.

Es sei erwähnt, daß es aus der Veröffentlichung "The two-chip integration for color television receivers" von M. Yoshitomi et al, IEEE Transactions on Consumer Electronics, Vol. CE-28, No. 3, August 82, Seiten 184 bis 191, zwar bekannt ist ein Keramikfilter in einem Fernsehgerät zu verwenden. Dieses Filter bezweckt jedoch nicht die Bandbegrenzung eines Fernseh-Luminanzsignals.

Nach einer Ausgestaltungsform der Erfindung ist vorgesehen, daß der Eingang über eine Reihenschaltung eines ersten Widerstandes, der Laufzeitleitung, eines zweiten und eines dritten Widerstandes mit dem Ausgang gekoppelt ist, daß der Verbindungspunkt zwischen dem zweiten und dem dritten Widerstand über das Keramikfilter gegen Masse geschaltet ist und daß der Ausgang über eine Parallelschaltung eines vierten Widerstandes und einer Kapazität ebenfalls gegen Masse geschaltet ist.

Bei diesem Schaltungsaufbau bewirkt das Keramikfilter eine besonders gute Dämpfung der höheren Frequenzen, da es der Reihenschaltung der ersten und zweiten Widerstände und der Laufzeitleitung nachgeschaltet ist, die relativ hochohmig sind. Am Ausgang des Filters werden die hohen Frequenzen nochmals durch die gegen Masse geführte Parallelschaltung eines Widerstandes an einer Kapazität gedämpft.

Nach einer anderen Ausgestaltungsform der Erfindung ist vorgesehen, daß der Eingang über eine Reihenschaltung eines ersten und eines zweiten Widerstandes und der Laufzeitleitung mit dem Ausgang gekoppelt ist, daß der Verbindungspunkt zwischen dem ersten und dem zweiten Widerstand
über das Keramikfilter gegen Masse geschaltet ist und der
Ausgang über einen dritten Widerstand ebenfalls gegen
Masse geschaltet ist.

Dieses Filter weist im wesentlichen die gleichen Vorteile
auf, jedoch ist hier nach dem Eingangswiderstand zunächst
das Keramikfilter angeordnet, dem über einen Anpassungswiderstand die Verzögerungsleitung nachgeschaltet ist.

Nach einer weiteren Ausgestaltung der Erfindung ist vorgesehen, daß dem Tiefpaß ein 5,5 MHz-Filter vorgeschaltet
ist.

Sollten am Video-Ausgang des gegebenenfalls vorgeschalteten ZF-Demodulators noch die Tonfrequenzen, also Frequenzen um 5,5 MHz austreten, so kann dem Tiefpaß ein
5,5-MHz-Filter vorgeschaltet sein. Dieses Filter kann
entweder bekannter Bauart sein, es kann sich jedoch auch
um ein gegen Masse geschaltetes Keramikfilter handeln.

Zwei Ausführungsbeispiele der Erfindung werden anhand der
Figuren näher erläutert. Es zeigen:

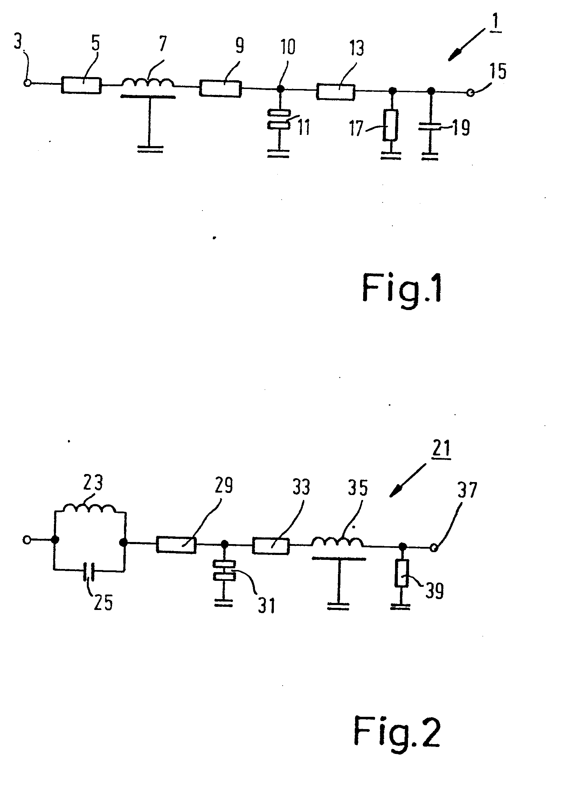

Fig. 1 einen Tiefpaß in einer ersten Ausführungsform,

Ein in Fig. 1 dargestellter Tiefpaß zur Bandbegrenzung des
Luminanzsignals in einem Videorecorder weist von seinem
Eingang 3 ab im Signalweg eine Reihenschaltung eines
ohmschen Eingangswiderstandes 5 einer Laufzeitleitung 7, eines ohmschen Anpassungswiderstandes 9 und eines weiteren ohmschen Ausgangswiderstandes 13 auf. An die Verbindung 10 zwischen dem Anpassungswiderstand 9 und dem Ausgangswiderstand 13 ist ein Keramikfilter 11 angeschaltet, das an Masse gelegt ist. Ausgangsseitig des Widerstandes 13 sind vor dem Ausgang 15 des Tiefpasses vom Signalweg aus ein ohmscher Widerstand 17 und eine Kapazität 19 gegen Masse geschaltet.

Am Eingang 27 des in Fig. 2 dargestellten Tiefpasses 21 ist im Signalweg ein 5,5-MHz-Filter bekannter Bauweise vorgesehen, das aus der Parallelschaltung einer Induktivität 23 und einer Kapazität 25 aufgebaut ist. Diesem 5,5-MHz-Filter ist der Tiefpaß 21 nachgeschaltet. Zwischen dem ohmschen Eingangswiderstand 29 und dem Anpassungswiderstand 33 ist ein Keramikfilter 31 gegen Masse geschaltet. Auf den ohmschen Anpassungswiderstand 33 folgt im Signalweg eine Laufzeitleitung 35, deren Ausgang den Ausgang 37 des Tiefpasses darstellt, an dem ein ohmscher Widerstand 39 gegen Masse geschaltet ist.

In beiden Ausführungsbeispielen wird für das Keramikfilter eine Resonanzfrequenz von 4,43 MHz gewählt, entsprechend der Farbträgerfrequenz, bei der es auf eine besonders gute Unterdrückung ankommt. Die Laufzeitleitung ist bekannter Bauart und hat z. B. einen Verzögerungswert von 680 nsec.

PATENTANSPRÜCHE

1. Tiefpaß zur Bandbegrenzung eines Fernseh-Luminanzsignals, insbesondere des Luminanzsignals im Aufnahmezweig einer Video-Aufzeichnungsvorrichtung vor einem FM-Modulator, mit einer in einen Signalweg zwischen einen Eingang und einen Ausgang des Tiefpasses geschalteten Laufzeitleitung zur Verzögerung des Fernseh-Luminanzsignals, dadurch gekennzeichnet, daß ein gegen Masse geschaltetes Keramikfilter vorgesehen ist zur Dämpfung der Signalanteile oberhalb einer Grenzfrequenz.

2. Tiefpaß nach Anspruch 1, dadurch gekennzeichnet, daß der Eingang über eine Reihenschaltung eines ersten Widerstandes, der Laufzeitleitung, eines zweiten und eines dritten Widerstandes mit dem Ausgang gekoppelt ist, daß der Verbindungspunkt zwischen dem zweiten und dem dritten Widerstand über das Keramikfilter gegen Masse geschaltet ist und daß der Ausgang über eine Parallelschaltung eines vierten Widerstandes und einer Kapazität ebenfalls gegen Masse geschaltet ist.

3. Tiefpaß nach Anspruch 1, dadurch gekennzeichnet, daß der Eingang über eine Reihenschaltung eines ersten und eines zweiten Widerstandes und der Laufzeitleitung mit dem Ausgang gekoppelt ist, daß der Verbindungspunkt zwischen dem ersten und dem zweiten Widerstand über das Keramikfilter gegen Masse geschaltet ist und der Ausgang über einen dritten Widerstand ebenfalls gegen Masse geschaltet ist.

4. Tiefpaß nach Anspruch 1, 2 oder 3, dadurch gekennzeichnet, daß dem Tiefpaß ein 5,5 MHz-Filter vorgeschaltet ist.

0207571

Fig.1

Fig.2

PHD 85-063